## Europäisches Patentamt

## European Patent Office

## Office européen des brevets

(11) Publication number: **0 213 657**
**B1**

---

(12) **EUROPEAN PATENT SPECIFICATION**

(45) Date of publication of patent specification: **02.01.91**

(51) Int. Cl.⁵: **H 02 H 9/00, H 03 H 1/00**

(21) Application number: **86201330.7**

(22) Date of filing: **28.07.86**

---

(54) **Device for protecting non-symmetric electric circuitry against high-energy interference voltages having steep transients.**

(30) Priority: **31.07.85 NL 8502163**

(43) Date of publication of application:
**11.03.87 Bulletin 87/11**

(45) Publication of the grant of the patent:
**02.01.91 Bulletin 91/01**

(84) Designated Contracting States:
**AT BE CH DE FR GB IT LI LU SE**

(56) References cited:
**EP-A-0 056 275**
**NL-C- 173 226**
**US-A-3 777 219**
**US-A-3 824 431**
**US-A-3 913 038**

(73) Proprietor: **Koninklijke PTT Nederland N.V.**
**P.O. Box 95321**
**NL-2509 CH The Hague (NL)**

(72) Inventor: **Keimpema, Keimpe Klaas**
**61 De Valeriaan**
**NL-8446 BC Heerenveen (NL)**
Inventor: **Ouderling, Joannes Marinus Gerardus Antonius**
**79 Gorterlaan**
**NL-9721 ZC Groningen (NL)**

Courier Press, Leamington Spa, England.

## Description

### A. Background of the invention
### 1. Field of the invention

The invention relates to overvoltage protective devices, and more in particular to a device for protecting non-symmetric electric circuitry against high-energy interference voltages resulting from electromagnetic disturbances having steep transient edges in accordance with the first part of Claim 1.

### 2. Prior art

A device of the above-described kind is known from European Patent 0056275 issued December 18, 1985, and having its content published from July 21, 1982. This prior art invention has as its main object to protect low-voltage power lines against high-energy interference voltage surges having very rapidly rising edges such as for example caused by a nuclear explosion. To achieve its object the above prior art relies on a combination of a short linear section of coaxial cable formed from added means and a wire portion ahead of a power line to be protected, and a following multi-stage interference voltage attenuating device enclosed within a metal housing. Such an attenuating device includes self-inductance inserted in a series path intermediate said linear coaxial cable section and a power line to be protected, and a number of varistor type elements inserted between such series path and ground. Apparently such a combination is capable of attenuating an incoming interference surge having a peak value of 500 kV and a rise time of 20 kV/ns by such an amount that at its output side where the circuit to be protected is connected, a residual voltage of some hundred volts is developed.

Dutch patent 173226, issued on November 19, 1983, discloses an overvoltage protective device specifically designed for protecting symmetric two-wire circuits against high-energy interference voltages of the above-described kind. This prior-art structure is adapted for leading transmission wires of one or more two-wire circuits through a wall portion of an enclosed space of the Faraday cage type, without deteriorating its electromagnetic screening characteristics, and for causing high voltage peaks induced in the transmission wire to be substantially reduced at the equipment side. Each of the transmission wires is connected to an overvoltage protective circuit, which is formed as a π-network having a coil inserted into its series path, while each of its transverse paths includes a varistor type component having a step-function characteristic. With this prior art it is further possible to meet requirements as to attenuation of cross talk between adjacent circuits.

Further US patent 3,913,038 discloses a radio frequency filter for a television receiver. It is an object of this prior art to reduce the amount of undesirable signals coupled to a tuner of such a television receiver resulting from electromagnetic radiation external to and coupled to a coaxial cable utilized to transmit desirable signals to the tuner. For achieving such an object this prior art proposes to couple external means to the outer conductor of such a coaxial cable for providing an increase in series impedance associated with such an outer conductor while maintaining the characteristic impedance of the coaxial cable. This prior art is moreover specifically designed for a system wherein the chassis of the television receiver is placed at a voltage above earth ground potential equal to that supplied by an alternating current source for supplying operating power to the receiver.

US patent 3,777,219 describes apparatus for protecting electronic circuitry against damaging and destructive effects of fast rise time electromagnetic pulses. Such an apparatus is inserted between two coaxial cables used to interconnect electronic equipment. This prior art apparatus is designed to reduce the amount of undesirable overvoltages induced across the inner and outer conductor of such a coaxial cable circuit. A special structure is proposed for minimizing detrimental effects caused by parasitic transverse self-inductances on the transmission characteristics of the coaxial cable circuit. This prior art neglects undesired effects resulting from strong currents which may be induced in the coaxial cable outer conductors.

### B. Summary of the Invention

Within the context of current practice it can be particularly useful to employ non-symmetric transmission lines, such as coaxial cables, as a transmission medium. for example for the transfer of digital signals. Then it is often required that such coaxial transmission lines, either separately, or tied together within one and the same cable, which thus includes several coaxial circuits, are led through a wall portion of an enclosed space of the Faraday cage type. Also because the physical length of coaxial lines extending within such enclosure to equipment installed therein, is often relatively long, each of the coaxial line circuits may act as a source of undesired and destructive radiation, if a fast transient voltage is induced therein as a result of some external disturbance.

It is an object of the invention to provide a device which, on the one hand, makes it feasible to lead one or more coaxial transmission lines through a wall portion of an enclosed space of the Faraday cage type, while, on the other hand, an effective protection is provided against the aforementioned destructive radiation. It is an attendant problem that prior art structures as disclosed in the aforementioned Dutch patent 173226 are incompatible with those of coaxial lines and/or cables having several of such coaxial lines included therein.

By its structure a protective device of the invention further has to meet the following requirements:

the quality of the transmission characteristics of coaxial circuitry to be protected has to be maintained without deterioration; cross-talk attenuation has to be above a certain level; and there has to be a high degree of freedom as to the selection of the location at which the outer conductor of the coaxial circuitry under consideration is connected to reference potential, such as for example earth potential.

With a view to the aforementioned objects and requirements a protective device is according to the invention characterized thereby that said self-inductance includes a coiled section of a coaxial line separated off from a coaxial cable and wound with a number of turns, said coiled section being arranged, within the housing, galvanically and electrically insulated from the housing, wherein one end of the outer conductor of said coaxial line constitutes said one end of said self-inductance connected to the terminal of the current conducting element, and the other end of the outer conductor is connected directly, or via a further voltage-dependent component, to the housing at its equipment side.

A protective device, wherein a partition within said housing provides therein a first compartment at the input side of said device and a second compartment at the output side of said device turned towards circuitry to be protected, is according to a preferred embodiment of the invention further characterized in that the outer conductor of the respective coiled section of a coaxial line disposed within said second compartment from a portion at the end turned towards said input side is connected to said housing through a high-energy current conductive element of the type in which an applied voltage exceeding a certain threshold causes its current conductivity to increase with high rapidity, said current conductive element being disposed within said first compartment, while said outer conductor from another portion at the end turned towards said output side is connected to said housing through a low-energy current conductive element of a type similar to the former type, said low-energy current element being disposed within said second compartment.

C. Short Description of the Drawing

The invention will be further elucidated with the help of a description of an embodiment and with reference to the drawing in which:

Fig. 1 shows a diagrammatic and partly sectional top view of an embodiment (the upper cover of which is partly taken away) of a protective device according to the invention; and

Fig. 2 shows a diagram of a section according to the line II-II in figure 1.

D. References

European patent 0056275
Netherlands patent 173226
United States patent 3,913,038
United States patent 3,777,219.

E. Description of an Embodiment

The embodiment shown in the figures, which does not limit the invention, has been designed for a telecommunication cable, comprising six coaxial lines. It is self-evident that the invention can also be utilized for more or less than six coaxial transmission lines. The protective device comprises a housing 1, closed on all sides and made of an electrically conductive material, e.g. steel plate, which housing can be mounted, by means of fastenings, which are not shown, on a wall, which is not shown, of an enclosed space of the sort denoted as the Faraday cage.

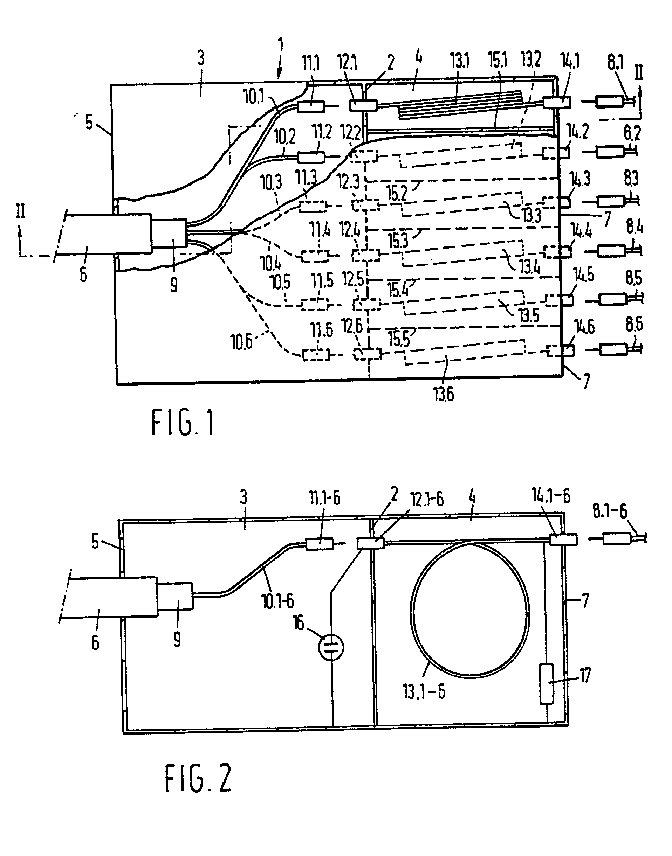

Figure 1 shows a top view for the case in which the upper cover of the housing 1 has been partly taken away. A partition 2, which is also made of an electrically conductive material, divides the interior of the housing 1 into a first compartment 3 and a second compartment 4. The front side 5 of the first compartment 3 is adapted in such a way that a telecommunication cable 6 can be led through and fastened, whereas the back side 7 is adapted in such a way that six separate coaxial lines 8.1 up to 8.6 inclusive can be led through, to which lines equipment, arranged within the enclosed space (Faraday cage), but not shown, can be connected. These coaxial lines are branched off from the cable 6, which is fastened to the housing 1 in a mechanical way by means of e.g. swivels (not shown) on the outwards and inwards turned sides of the front side 5. In the interior of the first compartment 3 the cable 6 has been finished in such a way that a relatively short longitudinal portion of the electrically conductive sheathing (lead sheathing), enclosing all the transmission wires and lines forming part of the cable, is uncovered. This sheathing portion 9 can be galvanically connected to the inside of the front side 5. Besides the cable 6 is spliced as diagrammatically shown in figure 1, so that the coaxial lines 10.1—10.6 forming part of that cable can be arranged separately and distributed over the space which is limited by the first compartment 3. Each of the free ends of these coaxial lines 10.1—10.6 is preferably finished with a coaxial insert connector 11.1—11.6. The partition 2 is provided with six complementary coaxial connectors 12.1—12.6, which are mounted in it in such a way that the outer conductor of each of these connectors 12.1—12.6 is galvanically electrically insulated with regard to the partition 2 and the housing 1. On the side facing the interior of the second compartment 4, each of said connectors 12.1—12.6 is connected in its turn to a coaxial line 13.1—13.6, thus forming six separate coaxial transmission paths insulatedly running through the partition 2. Each of the free ends (on the equipment side) of said coaxial lines 13.1—13.6 is connected to a coaxial connector 14.1—14.6, the construction or the mounting in the back side 7 of which is identical to those of the connectors 12.1—12.6. According to a preferred embodiment of the invention each of the coaxial lines 13.1—13.6 is disposed in a rolled-up form in the second compartment 4 as diagrammatically shown in figure 2 for one of the lines 13.1—13.6. The "coil" thus formed is designed e.g. with 8-10 windings. As the object of the construction is to form a barrier against peak overvoltages on the outer conductor, the value of the coil should be adapted to the components used and this value will also be determined by the capacitive properties of these components. In this way a low-pass filter will be formed, due to which high-frequency voltages are reflected and delayed, so that overvoltage protective components will get the time to become permeable and in this way it will be possible to derive low-frequency as well as high-frequency voltages. This self-induction has e.g. an order of magnitude of 30 μH. To improve the cross talk attenuation between neighbouring transmission circuits it is further advisable to separate the coaxial lines 13.1.13.6, rolled up as mentioned before, from one another by means of longitudinal partitions 15.1—15.5, which are connected in galvanical/mechanical way to the partition 2 and the back side 7.

As diagrammatically shown in figure 2, the outer conductor of each of the coaxial transmission paths running through the housing 1 is galvanically connected, both at the partition 2 and at the back side 7, to the housing 1, which is connected, via the wall of the enclosed space (Faraday cage), to reference potential, e.g. earth potential. Said galvanic connection takes place via a voltage dependent component, the conductivity of which will increase according to a step function, when a certain limiting voltage value is exceeded.

More in particular the outer conductor of each of the complementary coaxial connectors 12.1—12.6 is connected to a gas-discharge tube 16, connected to the housing and disposed in the first compartment 3, whereas the outer conductor of each of the coaxial connectors 14.1—14.6 is connected to a component 17 of the sort denoted as VDR or TransZorb, which is disposed in the relevant compartment of the second compartment 4. Under normal operating conditions the components such as 16 and 17 form such an impedance that the transmission properties of the relevant coaxial path along which an information signal is transmitted, will not be influenced to any extent. The same applies to each of the rolled-up coaxial lines 13.1—13.6.

With a device described above it is achieved that radiation coming from the coaxial lines 8.1—8.6, as a result of a destructive EM-pulse caused (e.g. by lightning or a nuclear explosion) outside the housing 1 and the enclosed space (Faraday cage), will within said enclosed space have been weakened to an intensity and form permissible for the equipment in said space; that interfering voltage peaks on the outer conductor of a coaxial line such as 8.1—8.6, and caused by a destructive EM-pulse referred to above will have been reduced to a level controllable for the equipment connected; that the transmission properties of a relevant coaxial circuit for signals containing normal information remain substantially unaltered; and that a relevant coaxial circuit can be earthed at a place which is, considered from a transmission-technical point of view, most favourable. If necessary, the additional protection between the inner and the outer conductor can be applied in the so-called Faraday cage, close to the equipment.

Other embodiments with an identical overvoltage protective potential with regard to asymmetrical transmission lines can be realized without leaving the scope of the invention laid down in the claims. For example for each of the coaxial transmission paths two of said "coils" connected in series can be disposed in the second compartment of the housing. In this case the coaxial outer conductor portion, located between these two coils, is galvanically connected to the housing via a separate voltage-dependent component, the conductivity of which will increase according to a step function, when a certain limiting voltage value is exceeded. Besides the voltage-dependent component, such as 17, located on the equipment side 7, can be dispensed with under certain circumstances. Instead of such a component it may be advisable to connect the outer conductor of the coaxial conductor at that place direct to the wall of the metal housing.

**Claims**

1. A device for protecting non-symmetric electric circuitry arranged within an enclosed space of the sort denoted as the Faraday cage against high-energy interference voltages resulting from electromagnetic disturbances having steep transient edges, the device comprising a closed metal housing (1) having a front side (5), through which a cable (6) susceptible to said interference voltages is led through, and an equipment side (7) to which circuitry (8.1—6) to be protected is connected, said metal housing including at least one voltage-dependent current conducting element (16) of the type in which an applied voltage exceeding a certain threshold value causes its current conductivity to increase with high rapidity, and at least one self-inductance (13.1—6) inserted in a series path between the cable (6) and the circuitry (8.1—6) to be protected, said current conducting element (16) having its one terminal galvanically connected to said housing (1), and its other terminal connected to one end of said self-inductance (13.1—6), characterized in that said self-inductance includes a coiled section (13.1—6) of a coaxial line separated off from a coaxial cable and wound with a number of turns, said coiled section being arranged, within the housing (1), galvanically and electrically insulated from the housing (1), wherein one end of the outer conductor of said coaxial line constitutes said one end of said self-inductance connected to the terminal of the current conducting element (16), and the other end of the outer conductor is connected directly, or via a further voltage-dependent component (17), to the housing (1) at its equipment side.

2. A device as in claim 1, characterized in that said housing (1) includes at least two self-inductances inserted in separate paths connected to different circuitry to be protected, in that a longitudinal partition (15.1—5) of electrically conducting material which is galvanically and mechanically connected to a back side (7) of said housing (1) separates said at least two self-inductances from each other, in that each of said at least two self-inductances includes a coiled section (13.1—6) of a coaxial line wound with a number of turns, the outer conductor of each of said sections of a coaxial line being galvanically and electrically insulated from said housing (1), and in that each of said sections of coaxial line is coupled to its individual electric circuit to be protected.

3. A device as in claim 1 or 2, characterized in that a partition (2) within said housing (1) provides therein a first compartment (3) at the input side of said device and a second compartment (4) at the output side of said device turned towards circuitry to be protected, and in that the outer conductor of the respective coiled section (13.1—6) of a coaxial line disposed within said second compartment (4) from a portion at the end turned towards said input side is connected to said housing (1) through a high-energy current conductive element (16) of the type in which an applied voltage exceeding a certain threshold causes its current conductivity to increase with high rapidity, said current conductive element (16) being disposed within said first compartment (3), while said outer conductor from another portion at the end turned towards said output side is connected to said housing through a low-energy current conductive element (17) of a type similar to the former type, said low-energy current element being disposed within said second compartment (4).

4. A device as in claim 1, 2 or 3, characterized in that for each coiled section (13.1—6) of a coaxial line the number of turns and the diameter thereof are selected to provide a self-inductance having a magnitude which is matched to the characteristics, in particular the capacitive characteristics, of the elements connected to the outer conductor of such a coiled coaxial line section (13.1—6).

**Patentansprüche**

1. Einrichtung zum Schutz unsymmetrischer elektrischer Schaltungen, die sich in einem eingeschlossenen Raum in der Art eines sogenannten Faraday-Käfigs befinden, gegen Hochenergie-Interferenzspannungen, die sich aus elektromagnetischen Störungen mit steilen Transientflanken ergeben, wobei diese Einrichtung ein geschlossenes Metallgehäuse (1) mit einer Frontseite (5), durch die ein auf solche Störspannungen empfindliches Kabel (6) durchgeführt ist, sowie eine Ausrüstungsseite (7) umfasst, an die die zu schützenden Schaltungen (8.1—6) angeschlossen sind, wobei dieses Metallgehäuse wenigstens ein spannungsabhängiges Stromleiterelement (16) von der Art, dass eine angelegte, einen gewissen Grenzwert überschreitende Spannung eine sehr schnelle Zunahme seiner Stromleitfähigkeit bewirkt, sowie mindestens eine in Reihe zwischen das Kabel (6) und die zu schützenden Schaltungen (8.1—6) eingefügte Selbstinduktivität (13.1—6) umfasst, und wobei der eine Anschluss dieses Stromleiterelementes (16) galvanisch mit diesem Gehäuse (1) und sein anderer Anschluss mit einem Ende dieser Selbstinduktivität (13.1—6) verbunden ist, dadurch gekennzeichnet, dass diese Selbstinduktivität einen spulenförmigen Abschnitt (13.1—6) einer von einem Koaxialkabel getrennten und mit einer Anzahl Windungen gewickelten Koaxialleitung umfasst, dass dieser spulenförmige Abschnitt innerhalb des Gehäuses (1) galvanisch und elektrisch vom Gehäuse (1) isoliert ist, dass ein Ende des Aussenleiters dieser Koaxialleitung dieses eine Ende der mit dem Anschluss des Stromleiterelementes (16) verbundenen Selbstinduktivität ist, und dass das andere Ende des Aussenleiters direkt oder über einen weiteren spannungsabhängigen Baustein (17) mit dem Gehäuse (1) an seiner Ausrüstungsseite verbunden ist.

2. Einrichtung nach Anspruch 1, dadurch gekennzeichnet, dass dieses Gehäuse (1) mindestens zwei Induktivitäten umfasst, die je in einen getrennten, mit jeweils verschiedenen zu schützenden Schaltungen verbundenen Pfad eingefügt sind, dass eine längliche mit der Rückseite (7) dieses Gehäuses (1) verbundene Trennwand (15.1—5) aus elektrisch leitendem Material diese mindestens zwei Induktivitäten voneinander trennt, dass jede dieser mindestens zwei Induktivitäten einen spulenförmigen Abschnitt (13.1—6) einer mit einer Anzahl Windungen gewickelten Koaxialleitung umfasst, wobei der Aussenleiter eines jeden dieser Koaxialleitungsabschnitte galvanisch und elektrisch von diesem Gehäuse (1) isoliert ist, und dass jeder dieser Koaxialleitungsabschnitte mit seinen individuellen elektrischen zu schützenden Schaltungen gekoppelt ist.

3. Einrichtung nach Anspruch 1 oder 2, dadurch gekennzeichnet, dass innerhalb dieses Gehäuses (1) eine Trennwand (2) vorhanden ist, die an der Eingangsseite der Einrichtung eine erste Abteilung (3) und an der Ausgangsseite der Einrichtung eine zweite Abteilung (4) bildet, die gegen die zu schützenden Schaltungen gerichtet ist, und dass der gegen die Eingangsseite gerichtete Endbereich des Aussenleiters des entsprechenden spulenförmigen Abschnitts (13.1—6) einer Koaxialleitung, die sich in dieser zweiten Abteilung (4) befindet, mit diesem Gehäuse (1) verbunden ist, und zwar über ein Hochenergie-Stromleiter-Element (16) der Art, dass eine angelegte einen gewissen Grenzwert überschreitende Spannung eine sehr schnelle Zunahme seiner Stromleitfähigkeit bewirkt, wobei dieses Stromleiter-Element (16) innerhalb der ersten Abteilung (3) angeordnet ist, während dieser Aussenleiter in seinem anderen, gegen die Ausgangsseite gerichteten Endbereich über ein Niederenergie-Stromleiter-Element (17) einer der ersten ähnlicher Art mit diesem Gehäuse verbunden ist, indem dieses Niederenergie-Stromelement innerhalb dieser zweiten Abteilung (4) angeordnet ist.

4. Einrichtung nach Anspruch 1, 2 oder 3, dadurch gekennzeichnet, dass für jeden spulenförmigen Abschnitt (13.1—6) einer Koaxialleitung die Anzahl Windungen und deren Durchmesser derart gewählt sind, um eine Selbstinduktivität zu erreichen, deren Wert der Charakteristik, insbesondere der kapazitiven Charakteristik der mit dem Aussenleiter eines solchen spulenförmigen Koaxialleitungsabschnitts (13.1—6) verbundenen Elemente angepasst ist.

## Revendications

1. Dispositif de protection d'un circuit électrique asymétrique placé dans un espace fermé du type appelé "cage de Faraday", contre des tensions constituant des interférences d'énergie élevée résultant de perturbations électromagnétiques ayant des flancs transitoires très nets, le dispositif comprenant un boîtier métallique fermé (1) ayant une face avant (5) par laquelle passe un câble (6) sujet aux tensions des interférences, et une face (7) disposée du côté d'un appareillage et à laquelle est connecté le circuit (8.1 à 8.6) à protéger, le boîtier métallique ayant au moins un élément conducteur de courant (16) qui dépend de la tension et du type dans lequel une tension appliquée qui dépasse une certaine valeur de seuil provoque une augmentation de la conductivité du courant avec une grande rapidité, et au moins une inductance (13.1 à 13.6) placée en série entre le câble (6) et le circuit (8.1 à 8.6) à protéger, l'élément conducteur de courant (16) ayant sa première borne qui est connectée galvaniquement au boîtier (1) et son autre borne qui est connectée à une première extrémité de l'inductance (13.1 à 13.6), caractérisé en ce que l'inductance comporte un tronçon enroulé (13.1 à 13.6) d'une ligne coaxiale séparée d'un câble coaxial et enroulée avec un certain nombre de spires, le tronçon enroulé étant disposé dans le boîtier (1) de manière qu'il soit isolé galvaniquement et électriquement du boîtier (1), une première extrémité du conducteur externe de la ligne coaxiale constituant la première extrémité de l'inductance connectée à la borne de l'élément conducteur de courant (16), et l'autre extrémité du connecteur externe étant connectée directement au boîtier (1) ou étant connectée à celui-ci par un autre composant (17) dépendant de la tension, du côté de l'appareillage.

2. Dispositif selon la revendication 1, caractérisé en ce que le boîtier contient au moins deux inductances placées dans des trajets séparés connectés à un circuit différent à protéger, en ce qu'une cloison longitudinale (15.1 à 15.5) d'un matériau conducteur électriquement, qui est connectée galvaniquement et mécaniquement à une face arrière (7) du boîtier (1), sépare les deux inductances au moins l'une de l'autre, en ce que chacune des deux inductances au moins comporte un tronçon enroulé (13.1 à 13.6) d'une ligne coaxiale enroulée avec un certain nombre de spires, le conducteur externe de chacun des tronçons de ligne coaxiale étant isolé galvaniquement et électriquement du boîtier (1), et en ce que chacun des tronçons de ligne coaxiale est couplé à son circuit électrique individuel à protéger.

3. Dispositif selon la revendication 1 ou 2, caractérisé en ce qu'une cloison (2) placée dans le boîtier (1) forme dans celui-ci un premier compartiment (3) placé du côté d'entrée du dispositif et un second compartiment (4) placé du côté de sortie du dispositif et tourné vers le circuit à protéger, et en ce que le conducteur externe du tronçon respectif enroulé (13.1 à 13.6) d'une ligne coaxiale placée dans le second compartiment (4), depuis une portion se trouvant à l'extrémité tournée vers le côté d'entrée, est connecté au boîtier (1) par l'intermédiaire d'un élément (16) conducteur de courant d'énergie élevée du type dans lequel la tension appliquée, lorsqu'elle dépasse un certain seuil, provoque une augmentation de la conductivité du courant avec une grande rapidité, l'élément conducteur de courant (16) étant placé dans le premier compartiment (3), alors que le conducteur externe d'une autre partie, placé à l'extrémité tournée vers le côté de sortie, est connecté au boîtier par un élément conducteur de courant (17) de faible énergie d'un type analogue au premier type, l'élément conducteur de courant de faible énergie étant placé dans le second compartiment (4).

4. Dispositif selon la revendication 1, 2 ou 3, caractérisé en ce que, pour chaque tronçon enroulé (13.1 à 13.6) d'une ligne coaxiale, le nombre de spires et le diamètre des spires sont choisis afin qu'ils donnent un coefficient d'autoinduction ayant une amplitude qui est adaptée aux caractéristiques des éléments connectés au conducteur externe d'un tel tronçon enroulé (13.1 à 13.6) de câble coaxial, en particulier aux caractéristiques capacitives de ces éléments.

FIG. 1

FIG. 2